Europäisches Patentamt

(19) European Patent Office

Office européen des brevets

(11) Publication number: **0 156 551**
**B1**

# EUROPEAN PATENT SPECIFICATION

(45) Date of publication of patent specification: **09.08.89**

(51) Int. Cl.⁴: **H 01 L 21/28,** H 01 L 29/40

(21) Application number: **85301534.5**

(22) Date of filing: **06.03.85**

(54) Ohmic contact for III-V semiconductor and method of forming it.

(30) Priority: **07.03.84 JP 43634/84**

(43) Date of publication of application:
**02.10.85 Bulletin 85/40**

(45) Publication of the grant of the patent:
**09.08.89 Bulletin 89/32**

(84) Designated Contracting States:
**DE FR GB IT NL**

(56) References cited:
**EP-A-0 037 005**
**US-A-3 987 480**

**PATENT ABSTRACTS OF JAPAN, vol. 8, no. 91,
26 April 1984, page (E-241) (1528); & JP-A-59-
9965 (MITSUBISHI) 19-01-1984**

**ELECTRONICS LETTERS, vol. 19, no. 21,
October 1983, London, GB; C.-Y. SU et al. "Low
contact resistance nonalloyed ohmic contacts
to Zn-implanted p+GaAs", pages 891-892**

(73) Proprietor: **SUMITOMO ELECTRIC INDUSTRIES
LIMITED
No. 15, Kitahama 5-chome Higashi-ku
Osaka-shi Osaka 541 (JP)**

(72) Inventor: **Himoto, Takeshi c/o Osaka Works
Sumitomo Electric
Industries Ltd 1-3, Shimaya 1-chome
Konohana-ku Osaka (JP)**

(74) Representative: **Rackham, Stephen Neil et al
GILL JENNINGS & EVERY 53-64 Chancery Lane
London WC2A 1HN (GB)**

Courier Press, Leamington Spa, England.

## Description

The present invention relates to a semiconductor device and a process for producing it. More particularly, the invention relates to an ohmic electrode formed on a p-type III—V compound semiconductor, and a process for producing it.

Conventionally such an ohmic electrode comprises a first layer of Au, a second layer of Zn and a third layer of Au. However, electromigration of the Au atoms from such an electrode into the semiconductor impairs the characteristics of the device and shortens its service life.

Another conventional ohmic electrode which overcomes this problem is formed by an assembly of a Ti layer, a metal layer made from Pt, Mo, W or Cr, and an Au layer. However this electrode has a comparatively high contact resistance.

A further known ohmic electrode described in EP—A—37005 comprises a first layer formed on the surface of a III—V compound semiconductor, a second layer of Zn, a third metal layer, and an Au top layer. This electrode is intended to be formed on an indium compound III—V semiconductor substrate and, in this case, the first layer is indium and the third layer is Ni-Cr or Pd or Pt.

According to a first aspect of this invention such an ohmic electrode has the first layer formed of titanium and the third layer being thin enough to facilitate the transfer of Zn through that layer made from Pt, Mo, W or Cr.

According to a second aspect of this invention in the production of an ohmic electrode in accordance with the first aspect of this invention comprises the following steps:

forming on the surface of a p-type III—V compound semiconductor (1) a first layer (8), a second layer (9) of Zn, a third metal layer (10) and, a top Au layer (11);

characterised by the formation of a Ti layer as the first layer (8) being thin enough to facilitate the transfer of Zn through that layer (8):

by the third layer (10) being of Pt, Mo, W or Cr; and,

by heat-treating the assembly either in a gaseous atmosphere including $H_2$, $N_2$, Ar or in a vacuum, so that Zn from the layer (9) migrates through the Ti layer (8) to reach the surface of the semiconductor (1), to form a layer of an alloy of the semiconductor and Zn.

The thickness of the Ti layer, as well as the temperature and period of alloying between Zn and the semiconductor are so selected that Zn penetrates through the Ti layer to form an alloy layer with the semiconductor. Because of the presence of this alloy layer, the electrode of the present invention has a low contact resistance.

A particular example of a method and an electrode in accordance with this invention will now be described with reference to the accompanying drawings; in which:—

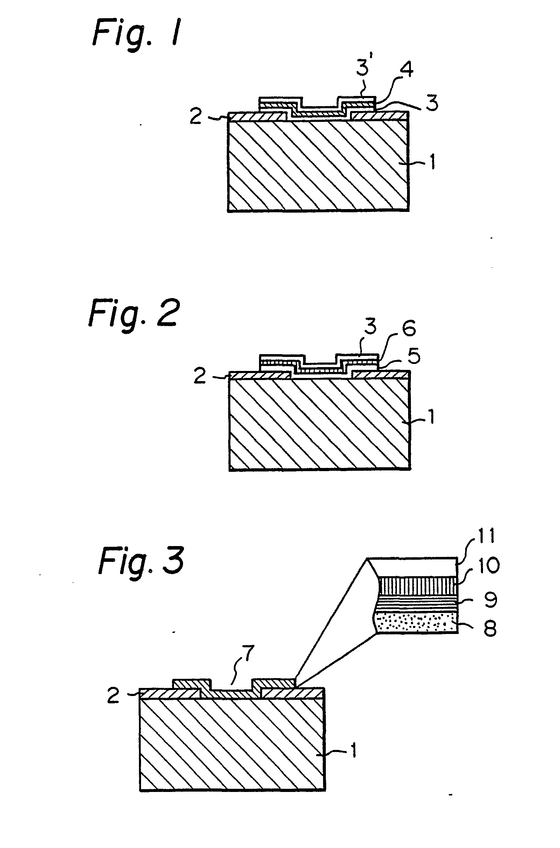

Figures 1 and 2 are cross sections through two conventional electrodes on a p-type III—V semiconductor; and, Figure 3 is a cross section through an electrode in accordance with the present invention on a p-type III—V semiconductor.

Conventional ohmic electrodes on a compound semiconductor are illustrated in Figures 1 and 2. The electrode in Figure 1 comprises a p-type III—V compound semiconductor substrate 1 which is overlaid successively with an insulating or protective $SiO_2$ or $Si_3N_4$ film 2, a first metal (Au) layer 3, a second metal (Zn) layer 4 and a third metal (Au) layer 3'. The electrode in Figure 2 consists of a p-type III—V compound semiconductor substrate 1 which is successively overlaid with a first metal (Ti) layer 5, a second metal layer 6 made of Pt, Mo, W or Cr, and a third layer (Au) layer 3.

The electrode in Figure 1 has a low contact resistance because Au forms an alloy layer with both the semiconductor and Zn. However, the electromigration of Au atoms into the bulk of the semiconductor impairs the characteristics of the device using the electrode and eventually shortens its service life. Another disadvantage is that the Au layer adheres so poorly to $SiO_2$ or $Si_3N_4$ film that the electrode easily separates from the semiconductor substrate. The electrode in Figure 2 has no such defects; firstly it minimizes the electromigration of Au atoms by a barrier layer 6 which is made of Pt, Mo, W or Cr that does not easily form an alloy with Au; secondly, the electrode separation is prevented by forming a Ti layer 5 which has good adhesion to the $SiO_2$ or $Si_3N_4$ film 2. However, this electrode does not have a low contact resistance comparable to that of the electrode shown in Figure 1 since Ti does not easily alloy with the semiconductor.

The ohmic electrode of the present invention is illustrated in Figure 3. A p-type III—V semiconductor substrate which is generally shown at 1 is made of a single layer of GaAs, InP, InGaAs or InGaAsP or a laminate of such layers. An insulating and protective film 2 of $SiO_2$, $Si_3N_4$ or $Al_2O_3$ is formed on the semiconductor substrate by a suitable thin-film forming technique such as CVD or sputtering. A window 7 is cut in the protective film 2 by photolithography. A metal layer assembly in accordance with the present invention is deposited on the semiconductor substrate showing in the window and the protective layer around the window. An enlarged view of the metal layer assembly is shown on the upper right side of Figure 3. The assembly contains a first thin metal (Ti) layer 8 which is formed by vacuum evaporation or sputtering. Above the Ti layer are formed a Zn layer 9, a Mo layer 10 and an Au layer 11. Each of these layers is formed by the same method used in depositing the Ti layer, and has a thickness in the range of 10 nm to 1 μm.

The reasons for assembly of the four metal layers in a lamination are described below. The Ti layer 8 has good adherence to the $SiO_2$ or $Si_3N_4$ film 2 and is inserted in order to prevent electrode separation from the semiconductor substrate. The Zn layer 9 is formed so that, as a result of alloying following the electrode fabrication, Zn diffuses through the Ti layer to reach the semiconductor surface where it forms an alloy layer with the semiconductor, thereby ensuring a low contact resistance for the electrode. The Ti layer 8 must be thin enough (e.g., 5 nm) to facilitate the transfer of Zn through that layer. The Mo layer 10 is used to minimize the electromigration of Au atoms from the Au layer 11 since Mo is a high-melting metal and does not easily form an alloy with Au. The topmost Au layer 11 is provided for the purpose of facilitating the subsequent die bonding and wire bonding.

After forming these metal layers, those portions which are not used as the electrode are removed by the combination of photolithographic techniques and chemical etching, plasma etching or lifting-off.

Subsequently, the device is subjected to heat treatment either in a gaseous atmosphere made of $H_2$, $N_2$, Ar or mixtures thereof or in a vacuum, so that Zn atoms in the second layer 9 penetrate through the Ti layer to reach the surface of the p-type III—V compound semiconductor and form a layer made of a Zn alloy with this semiconductor.

As shown above, the electrode of the present invention has a Zn layer formed on the Ti layer in the conventional type of electrode shown in Figure 2. By properly selecting the thickness of the Ti layer and the alloying conditions, Zn atoms penetrate through the Ti layer to form an alloy layer on the surface of the semiconductor substrate. The electrode of the present invention so constructed has a low contact resistance comparable to that of the conventional electrode shown in Figure 1 and, at the same time, the Au electromigration which occurs in this electrode is suppressed as in the conventional electrode shown in Figure 2.

Having the advantages shown above, the present invention provides a novel ohmic electrode suitable for use with light-emitting diodes, light-receiving diodes and other semiconductor devices using semiconducting compounds such as GaAs and InP.

## Claims

1. A semiconductor device including an ohmic electrode which is formed on the surface of a p-type III—V compound semiconductor (1) by an assembly of a first layer (8) formed on the surface of the compound semiconductor (1), a second layer (9) of Zn, a third metal layer (10), and an Au top layer, characterised in that the first layer (8) is a Ti layer being thin enough to facilitate the transfer of Zn through that layer (8), and in that the third layer is made from Pt, Mo, W or Cr.

2. A process for producing an ohmic electrode comprising the following steps:
forming on the surface of a p-type III—V compound semiconductor (1) a first layer (8), a second layer (9) of Zn, a third metal layer (10) and, a top Au layer (11);
characterised by the formation of a Ti layer as the first layer (8) being thin enough to facilitate the transfer of Zn through that layer (8):
by the third layer (10) being of Pt, Mo, W or Cr; and,
by heat-treating the assembly either in a gaseous atmosphere including $H_2$, $N_2$, Ar or in a vacuum, so that Zn from the layer (9) migrates through the Ti layer (8) to reach the surface of the semiconductor (1), to form a layer of an alloy of the semiconductor and Zn.

## Patentansprüche

1. Halbleitervorrichtung mit einer Ohmschen Elektrode, die auf der Oberfläche eines III—V-Verbindungs-Halbleiters (1) des p-Typs von einem Aufbau aus einer ersten Schicht (8), die auf der Oberfläche des Verbindungs-Halbleiters (1) ausgebildet ist, einer zweiten Schicht (9) aus Zn, einer dritten Metallschicht (10) und einer Au-Oberschicht gebildet ist, dadurch gekennzeichnet, daß die erste Schicht (8) eine Ti-Schicht ist, die zum Erleichtern der Übertragung von Zn durch diese Schicht (8) ausreichend dünn ist, und daß die dritte Schicht aus Pt, Mo, W oder Cr hergestellt ist.

2. Verfahren zur Herstellung einer Ohmschen Elektrode, das die folgenden Schritte umfaßt:
das Ausbilden einer ersten Schicht (8), einer zweiten Schicht (9) aus Zn, einer dritten Metallschicht (10) und einer oberen Au-Schicht (11) auf der Oberfläche eines III—V-Verbindungs-Halbleiters (1) des p-Typs, gekennzeichnet durch
die Ausbildung einer Ti-Schicht als die erste Schicht (8), die zum Erleichtern der Übertragung von Zn durch diese Schicht (8) ausreichend dünn ist,
das Bestehen der dritten Schicht (10) aus Pt, Mo, W oder Cr, und
Wärmebehandeln des Aufbaus entweder in einer Gasatmosphäre, die $H_2$, $N_2$, Ar umfaßt, oder in einem Vakuum, so daß Zn aus der Schicht (9) durch die Ti-Schicht (8) zum Erreichen der Oberfläche des Halbleiters (1) zur Bildung einer Schicht aus einer Legierung des Halbleiters und Zn hindurchwandert.

## Revendications

1. Dispositif semi-conducteur comprenant une électrode ohmique qui est formée à la surface d'un semi-conducteur composé III—V du type p (1) par un assemblage d'une première couche (8) formée à la surface du semi-conducteur composé (1), d'une deuxième couche (9) de Zn, d'une troisième (10) de métal et d'une couche supérieure de Au, caractérisé en ce que la première couche (8) est une couche de Ti qui est suffisamment mince pour faciliter le transfert de Zn à travers cette couche (8) et en ce que la troisième couche est faite de Pt, Mo, W ou Cr.

2. Procédé de production d'une électrode ohmique comprenant les étapes suivantes:
former à la surface d'un semi-conducteur composé III—V du type p (1), une première couche (8), une deuxième couche (9) de Zn, une troisième couche (10) de métal et une couche supérieure de Au (11);

caractérisé par la formation d'une couche de Ti en tant que première couche (8) qui est suffisamment mince pour faciliter le transfert de Zn à travers cette couche (8);

par la troisième couche (10) qui est faite de Pt, Mo, W ou Cr; et

par le traitement thermique de l'assemblage soit dans une atmosphère gazeuse contenant $H_2$, $N_2$, Ar ou sous vide, de manière que Zn de la couche (9) émigre à travers la couche (8) de Ti pour atteindre la surface du semi-conducteur (1) pour former une couche d'une alliage du semi-conducteur et de Zn.

*Fig. 1*

*Fig. 2*

*Fig. 3*

1